# EUROPÄISCHE PATENTSCHRIFT

(11) **EP 1 621 879 B1**
(45) Veröffentlichungstag und Bekanntmachung des Hinweises auf die Patenterteilung: **10.02.2010**
(21) Anmeldenummer: 05015591.0
(22) Anmeldetag: 19.07.2005
(51) Int. Cl.: G01N 29/36, G01N 29/24

(54) **Ultraschallempfänger mit frühzeitiger Signaldigitalisierung und dessen Verwendung**
Ultrasound receiver with early signal digitalisation and its use
Recepteur ultrasonore avec digitalisation prématuré de signaux et son utilisation

(30) Priorität: 23.07.2004 DE 102004035950
(43) Veröffentlichungstag der Anmeldung: 01.02.2006
(73) Patentinhaber: Betriebsforschungsinstitut VDEh Institut für angewandte Forschung GmbH, 40237 Düsseldorf (DE)
(72) Erfinder: Oberhoff, Dietmar, 42799 Leichlingen (DE); Flohr, Guido, 50354 Hürth (DE); Coen, Günther, Dr., 42549 Velbert (DE)
(74) Vertreter: Tilmann, Max Wilhelm

(56) Entgegenhaltungen:
- WO-A-99/23760
- US-A- 4 090 145
- US-A- 5 987 966
- US-A- 6 033 225
- US-A1- 2002 176 577
- US-A1- 2003 028 103
- PATENT ABSTRACTS OF JAPAN Bd. 011, Nr. 386 (P-647), 17. Dezember 1987 (1987-12-17) & JP 62 153746 A (MITSUBISHI ELECTRIC CORP), 8. Juli 1987 (1987-07-08)
- K.-R. FINK, F. HÖLZEL: "Empfangskonzeot für einen digitalen Empfänger" NTZ ARCHIV, Bd. 5, Nr. 12, 1983, Seiten 353-358, XP009057501 WEST GERMANY ISSN: 0170-172X

## Beschreibung

Die Erfindung betrifft einen Ultraschallempfänger und die Verwendung eines Ultraschallempfängers. Ultraschallempfänger und dessen Verwendung.

Ultraschallempfänger können beispielsweise bei der zerstörungsfreien Materialprüfung, insbesondere von Rohren, Drähten oder Bändern, eingesetzt werden. Hierzu wird eine Ultraschallwelle in dem Prüfkörper erzeugt, beispielsweise mittels eines piezoelektrischen Prüfkopfs oder - berührungslos - mittels eines EMATs. Das ausgesendete Ultraschallsignal wird von dem Ultraschallempfänger aufgenommen und in ein Signal umgewandelt. Aus dem Verlauf des Signals wird eine Information über Materialfehler im Prüfkörper gewonnen. Allerdings besteht beim Einsatz von EMATs das Problem, daß die erzeugbaren Ultraschall-Amplituden sehr klein sind, da ein EMAT ca. 10% der Effektivität eines Piezoelektrischen Wandlers aufweist. Zur Abhilfe werden teure, leistungsfähige Sender eingesetzt.

Insbesondere auf dem technischen Gebiet der zerstörungsfreien Materialprüfung werden Ultraschallempfänger in stark störsignalbehafteten Umgebungen eingesetzt. Bei der Materialprüfung von Bändern in einem Walzwerk werden durch die Antriebe der Walzgerüste starke Störsignale erzeugt. Diese Störsignale stören auch die Aufbereitung des in ein Signal umgewandelten Ultraschallsignals. Solche Störungen reduzieren die Aussagekraft des Messsignals. Teilweise ist keine sinnvolle Analyse des Signals möglich.

In der Vergangenheit ist versucht worden, die dem Ultraschallwandler nachfolgende analoge Elektrik Störungen gegenüber abzuschirmen. Derartige Abschirmungen sind jedoch kostenaufwendig. Ferner ist in einer Vielzahl von Einsatzgebieten der Bauraum in unmittelbarer Nähe des Ultraschallwandlers des Ultraschallempfängers begrenzt. Deshalb wird der Ultraschallwandler in der Regel getrennt von der nachgeschalteten analogen Analyseelektrik ausgeführt. Durch diese unabänderbaren räumlichen Gegebenheiten war es in der Vergangenheit notwendig, den Ultraschallwandler über bis zu 30 m lange Kabel mit der Auswerteelektronik zu verbinden. Diese Verbindungsleitungen, aber auch die Auswerteelektronik selbst sind den starken Störsignalen der Arbeitsumgebung ausgesetzt, so dass in der Vergangenheit Signale mit großem Signal-Rauschverhältnis und großem Signal-Störabstand mit einem Ultraschallempfänger nicht zu generieren waren.

Ferner ist auf dem technischem Gebiet des Mahlens von Kohle aus der US 5,987,966 eine Vorrichtung zur kontinuierlichen Bestimmung der Kohlemenge in dem Mahlwerk bekannt. Eine Ultraschallwelle wird durch das Mahlwerk von einem Ultraschallwellensender zu einem Ultraschallwellenempfänger geschickt. Der Ultraschallwellenempfänger weist einen Schaltkreis auf, der die Kohlenmenge durch einen Vergleich des empfangenen Signals mit Kalibrierwerten ermitteln kann. Das von dem Empfänger empfangene Signal wird durch einen entsprechenden Verstärker verstärkt und dann in ein digitales Signal durch einen Analog/Digitalkonverter konvertiert. Durch einen Amplitudenvergleich des nun digitalisierten Signals mit einem Reverenzsignal kann die Kohlenmenge in den Mahlwerk bestimmt werden.

Aus EP 1 416 443 ist eine Bildverarbeitungsvorrichtung und eine Ultraschall-Diagnose-Vorrichtung bekannt, bei der ein Glätten mittels eines Median-Filters erfolgt. Aus US 2002/0060751 ist es aus einer Vorrichtung zum Empfangen und Weiterverarbeiten von digitalen und/oder analogen Radiofrequenz-Signalen bekannt, Rauschen mittels eines Median-Filters aus einem Signal heraus zu filtern.

Vor diesem Hintergrund liegt der Erfindung die Aufgabe zugrunde, einen Ultraschallempfänger mit großem Signal-Rauschverhältnis und großem Signal-Störabstand vorzuschlagen.

Diese Aufgabe wird durch den Gegenstand des Anspruchs 1 gelöst. Vorteilhafte Ausgestaltungen sind in den Unteransprüchen angegeben.

Die Erfindung geht von dem Grundgedanken aus, das von dem Ultraschallwandler erzeugte analoge Signal frühzeitig zu digitalisieren. Dies erfolgt erfindungsgemäß bereits zwischen dem Ultraschallwandler und dem Demodulator.

Durch die frühzeitige Digitalisierung des vom Ultraschallwandler erzeugten analogen Signals wird in der weiteren Signalverarbeitung des Ultraschallempfängers ein digitales Signal bearbeitet, das gegenüber Störsignalen unempfindlicher ist. Die frühzeitige Digitalisierung erlaubt es ferner, die nutzbare Signaldynamik zu erhöhen. Während mit den herkömmlichen Systemen eine Signaldynamik von ca. 65 dB üblich war, ermöglicht es das erfindungsgemäße System eine Signaldynamik von 120 dB (Signal-Dynamik 1.000.000/1) zu nutzen. Diese Signaldynamik kann mit dem Fortschreiten der Taktfrequenz und der Auflösung der digitalen Komponenten der Auswerteelektronik zukünftig sogar noch erhöht werden. Erst dieser durch die Erfindung möglich gemachte Dynamikbereich erlaubt es, das System insoweit zu vereinfachen, dass kein steuerbarer sondern nur ein konstanter Vorverstärker eingesetzt werden kann, da die vom Ultraschallwandler erzeugten analogen Signale nur grob an den Dynamikbereich der Analog/Digital-Wandler angepasst werden müssen. Durch eine Vorverstärkung kann die Spannung des analogen Signals an den Eingangsspannungsbereich des Analog/Digital-Wandlers angepaßt werden. Die gesamte weitere Signalverarbeitung erfolgt digital. Durch den Einsatz eines konstanten Vorverstärkers werden wiederum störanfällige, insbesondere analoge Komponenten vereinfacht bzw. eingespart, so dass auch vor dem Analog/Digital-Wandler Reduktionen der Störungen der Signale erzielt werden.

Der überwiegend digitale Aufbau der Signalverarbeitung erlaubt es, die Signalverarbeitungseinheit mit einem einzigen Netzteil zu versorgen. Da nur ein Netzteil verwendet werden muß, kann dieses mit größerem Aufwand abgeschirmt werden, ohne zu hohe Kosten zu verursachen: Bei herkömmlichen analogen Signalverarbeitungseinheiten wurden die unterschiedlichen Bauelemente mit unterschiedlichen Netzteilen versorgt werden. Dies erhöhte zum einen die Stellen, an denen Störungen in das System eingebracht wurden. Zum anderen entstanden durch die Abschirmung der Mehrzahl von Netzteilen hohe Kosten, die häufig dazu führten, daß die Netzteile nur unzureichend abgeschirmt wurden.

Erfindungsgemäß wird als Ultraschallwandler insbesondere ein EMAT eingesetzt. Es können aber auch piezoelektrische Wandler oder dergleichen eingesetzt werden.

Insbesondere bevorzugt wird ein Analog/Digital-Wandler eingesetzt, der eine Auflösung von mindestens 14-Bit und eine Taktfrequenz von mindestens 50 MHz vorzugsweise mindestens 80 MHz aufweist. Bei der Auswahl der Auflösung und der Taktfrequenz des Analog/Digital-Wandlers gilt es den besten Kompromiß zwischen dem Gerätepreis (nimmt vornehmlich mit der Auflösung zu) und der Auflösung zu wählen. Während durch eine Erhöhung der Auflösung um ein Bit die Auflösung verdoppelt wird, wird durch eine Verdopplung der Taktfrequenz lediglich eine Verbesserung von √2 erreicht. Durch die Erhöhung der Auflösung ist es möglich, auch bei niedrigerer Taktfrequenz präzisere Signale zu erzeugen, als beispielsweise mit einem Analog/Digital-Wandler, der eine Auflösung von 8-Bit und eine Taktfrequenz von 500 MHz aufweist, auch wenn derartige Analog/Digital-Wandler durchaus in dem erfindungsgemäßen Ultraschallempfänger eingesetzt werden können.

Besonders bevorzugt führt der digitale Demodulator eine Hilbert-Transformation durch. Eine derartige Demodulation wird unter anderem in A. V. Oppenheim und R.W. Schafer, Discret time signal processing, Prantice Hall, New Jersey, 2^{nd} edition, 1999, beschrieben. Hilbert-Transformatoren werden teilweise auch als Quadraturdemodulatoren bezeichnet.

Eine Hilbert-Transformation oder eine der Hilbert-Transformation sehr ähnlich Transformation wird erreicht, wenn der Demodulator einen sog. "quadrature numerically controlled oscillator" (NCO), einen I/Q-Mischer, ein sog. "cascaded-integrator-comb"-Filter (CIC-Filter), ein FIR-Filter (finiteimpuls-response-Filter) und einen "Cartesian-to-Polar"-Konverter aufweist. Die Auslegung von FIR-Filtern ist beispielsweise in Tietze, Schenk, Halbleiter-Schaltungstechnik, Springer, Heidelberg, 2002, 12. Auflage, S. 1031 ff. beschrieben. I/Q-Mischer, wie sie vorzugsweise als Teil des Demodulators eingesetzt werden, werden bei Tietze, Schenk beispielsweise auf Seite 1308 ff. beschrieben.

Der Ultraschallempfänger weist ein Median-Filter auf. Das Median-Filter ist derart ausgelegt, dass es ein Ausgangssignal erzeugt, das durch die Median-Filterung einer Sequenz von digitalen Signalen ermittelt wurde.

Bei der zerstörungsfreien Materialprüfung wird von dem Ultraschallsender eine zeitlich gestaffelte Sequenz von Signalen ausgesandt. Beispielsweise werden 100 bis 150 Signale pro Sekunde ausgesendet. Der Ultraschallwandler nimmt in einem zeitlichen Fenster die ihn passierenden Ultraschallwellen auf und wandelt sie in ein elektrisches Signal um. Dabei wird als Fenster häufig der Bereich des Passierens der unmittelbar vom Sender zum Empfänger durch den Prüfkörper laufenden Ultraschallwelle bis zu einem festgelegten Abklingzeitpunkt gewählt. Das vom Ultraschallwandler erzeugte elektrische Signal gibt damit das Passieren der unmittelbar vom Sender zum Empfänger durch den Prüfkörper laufenden Ultraschallwelle und das - spätere - Passieren möglicher Reflektionen von sich in andere Richtungen ausbreitenden Teilen der ausgesendeten Ultraschallwelle wieder In Bezug auf die Median-Filterung wird als nächstes Signal der zu filternden Sequenz von Signalen der Teil des vom Ultraschwandler erzeugten elektrischen Signal angesehen, dessen Fenster beispielsweise mit dem Passierens der unmittelbar vom Sender zum Empfänger durch den Prüfkörper laufenden nächsten Ultraschallwelle beginnt. Die Fenster sind derart festgelegt, daß sie einen vergleichbaren Anfangszeitpunkt, beispielsweise das Aussenden des jeweiligen Ultraschallsignals aufweisen.

Bei der Prüfung von Metallbändern, bei denen ein 2m breiter Bereich geprüft wird, kann ein Fenster 400µs betragen und das nächste Signal nach ca. 6 ms gesendet werden. Das bei der Beobachtung des 400µs erzeugte Signal wird bei der Signalverarbeitung beispielsweise in eine Reihe von 32 000 Abtastpunkten umgesetzt.

Nach der Demodulation besteht jedes Signal aus einer Reihe von Werten, bei der der in der Reihe jeweils nachfolgende Wert den Wert der nächsten Abtastung wiedergibt. Die Reihe weist m Werte auf, wobei m die Zahl der Abtastungen in dem für die Signalerzeugung beobachteten Fenster ist.

Das Median-Filter nimmt bei dem erfindungsgemäßen Ultraschallempfänger die Reihe der abgetasteten Werte eines digitalisierten Signals in einen Array auf. Für die Reihe der Abtastwerte des nächsten Signals wird ein weiterer Array beschrieben. Durch den vergleichbaren Anfangszeitpunkt der für die Signalerzeugung beobachteten Fenster und die gleich Abtastung sind an gleichen Stellen des jeweiligen Arrays die an dem im Vergleich zum Anfangszeitpunkt jeweils gleichen Abtastzeitpunkt abgetasteten Werte abgelegt.

In dem Filter werden n Arrays beschrieben, wobei n die Zahl der Signale ist, die das Median-Filter auswertet, um das Ergebnis-Array zu erzeugen (vorzugsweise ist n eine ungerade Zahl, insbesondere 3, 5, 7). Für die Filterung eines Abtastpunkts liest das Median-Filter die n diesem Abtastpunkt zugeordneten Werte in den n Arrays aus, sortiert die ausgelesenen Werte ihrer Größe nach und gibt den Wert in der Mitte (Median-Wert) aus. Bei n=3 ist das der Wert an zweiter Stelle, bei n=5 der Wert an der dritten Stelle, etc.

Der Wert in der Mitte wird in ein Ergebnis-Array geschrieben, der in ein Ausgabesignal umgesetzt oder als Ausgangssignal verwendet werden kann.

Das Median-Filter erlaubt es, stochastische Störungen, die asynchron mit der Signalwiederholfrequenz auftreten, auszufiltern.

Der Ultraschallempfänger kann einen schaltbaren Bypass für das Median-Filter aufweisen, so dass die Signale an dem Median-Filter vorbeigeführt werden können. Dies erlaubt beispielsweise eine Analyse der Wirkungsweise und Effektivität des Median-Filters.

Insbesondere bevorzugt weist der Ultraschallempfänger einen Anschluss zu einem Computemetzwerk, insbesondere einem Internet auf. Insbesondere bevorzugt ist der Anschluß ein Ethernet-Anschluß, vorzugsweise mit TCP/IP-Protokoll. Die Datenübertragung innerhalb des Computernetzwerks kann optisch erfolgen, wodurch das Ultraschallsystem galvanisch vom Computersystem getrennt ist und die Störung der Signale weiter reduziert wird.

Insbesondere bevorzugt ist der Ultraschallempfänger derart ausgebildet, dass er Signale nur für Ultraschallsignale ausgibt, die den Ultraschallwandler in gleicher Richtung passieren. Durch diese Unidirektionalität kann verhindert werden, dass ein Ultraschallempfänger z. B. Rückwandechos, die aus der rückwärtigen Richtung empfangen werden oder dergleichen, Fehlsignale aufnimmt. Insbesondere kann der Ultraschallempfänger hierfür mit einem ersten Ultraschallwandler zum Erzeugen eines ersten analogen Signals, einem ersten Analog/Digital-Wandler zum Erzeugen eines ersten digitalen Signals, einem zweiten Ultraschallwandler zum Erzeugen eines zweiten analogen Signals, einem zweiten Analog/Digital-Wandler zum Erzeugen eines zweiten digitalen Signals, und einem Demodulator zum Erzeugen eines demodulierten digitalen Signals ausgebildet sein. Die Ultraschallwandler können räumlich versetzt zu einander angeordnet sein, insbesondere um λ/4 des aufzunehmenden Ultraschallsignals. Mit den vorgenannten Ausführungformen kann bei einem ersten Signal und einem zweiten Signal ein sog. Vor-Rückverhältnis von mindestens 25 dB und teilweise mehr als 40 dB eingestellt werden.

Bei den vorgenannten Ausführungsformen wird die Unidirektionalität insbesondere durch einen Multiplizierer für das erste digitale Signal, ein Verzögerungsglied für das zweite digitale Signal und einen Addierer zur Addition des digitalen Ausgangssignals des Multiplizierers und des digitalen Ausgangssignals des Verzögerungsglieds erreicht. Das Verzögerungsglied kann das zweite digitale Signal um die Laufzeit verkürzen, die bei der Frequenz des aufgenommen Ultraschallsignals dem Abstand dies zweiten Ultraschallwandlers vom ersten Ultraschallwandler entspricht. Je nach Signallaufrichtung werden dadurch die versetzt aufgenommenen Signale konstruktiv addiert oder - bei entgegengesetzter Laufrichtung - destruktiv addiert, so dass sich die Signale bei einer Laufrichtung zumindest nahezu aufheben.

Insbesondere bevorzugt ist ein Multiplizierer mit einstellbarem Multiplikationsfaktor und/oder ein Verzögerungsglied mit einstellbarer Verzögerung vorgesehen. Ein Analyseglied zur Beobachtung des ersten und des zweiten digitalen Signals kann den Multiplikationsfaktor und/oder die einzustellende Verzögerung ermitteln. Durch das Einstellen des Multiplikationsfaktors oder des Verzögerungsglieds können fertigungsbedingte Ungenauigkeiten im Aufbau des Ultraschallwandlers ausgeglichen werden, beispielsweise beim Abstand der beiden Ultraschallwandler zur Oberfläche des zu prüfenden Materials oder bei der Aufnahmeempfindlichkeit des jeweiligen Ultraschallwandlers. Insbesondere kann das Analyseglied die einzustellende Verzögerung anhand der relativen Lage der Nulldurchgänge des ersten und des zweiten digitalen Signals zueinander ermitteln. In der Regel beträgt die Verzögerung bei einem Versatz der Ultraschallsender von λ/4 t/4.

Insbesondere bevorzugt wird der erfindungsgemäße Ultraschallempfänger bei der zerstörungsfreien Materialprüfung und besonders bevorzugt bei der zerstörungsfreien Materialprüfung von Metallen (Bändern, Rohren, Drähten) während ihrer Herstellung, bzw., formgebenden Weiterbearbeitung eingesetzt. Besonders in diesem technischen Gebiet kommen Bearbeitungsmaschinen zum Einsatz, die starke Störsignale ausstrahlen, so daß bei herkömmlichen Ultraschallempfängern kein großes Signal-Rauschverhältnis und kein optimaler Signal-Störabstand festzustellen war.

Nachfolgend wird die Erfindung anhand einer lediglich ein Ausführungsbeispiel darstellender Zeichnung näher erläutert. Darin zeigen:
- Fig. 1: ein Blockschaltbild des erfindungsgemäßen Signalempfängers und
- Fig. 2: ein Ablaufschema der Arbeitsweise des Median-Filters des erfindungsgemäßen Ultraschallempfängers.

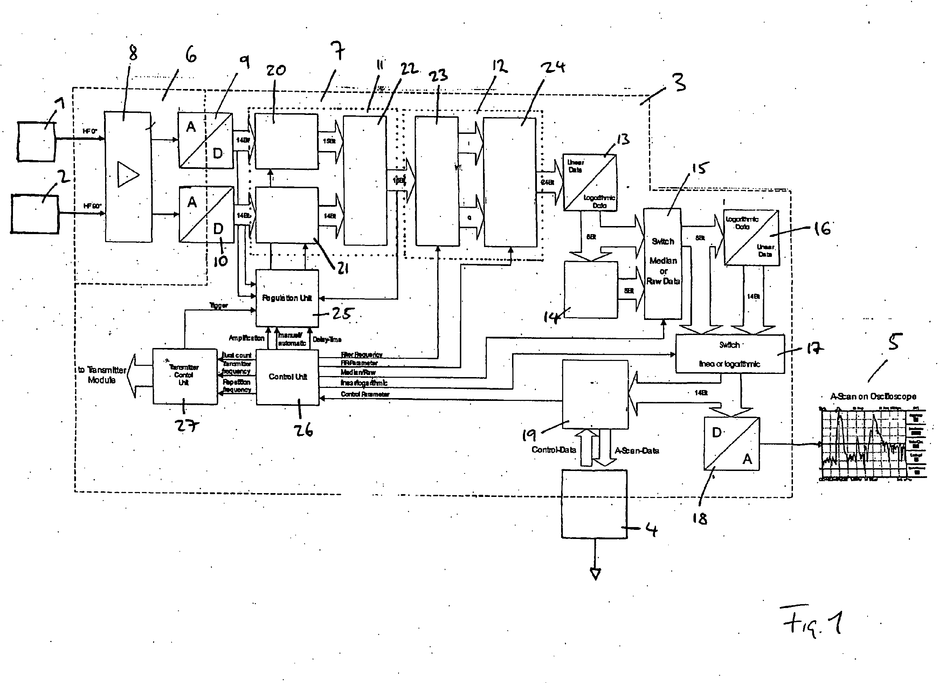

Der in Fig. 1 dargestellte Ultraschallempfänger weist zwei Ultraschallwandler 1, 2, eine an die Ultraschallempfänger 1, 2 angeschlossene Signalverarbeitungseinheit 3 und als Ausgänge der Signalverarbeitungseinheit 3 einen Ethernet Anschluss 4 und eine Anzeige 5 in Form eines Oszilloskops auf.

Die Ultraschallwandler sind vorzugsweise als EMAT ausgebildet. Die Spule des EMAT des Ultraschallempfängers 1 ist bezüglich der Spule des EMAT des Ultraschallempfängers 2 um die Distanz einer Viertelswellenlänge (λ/4) versetzt. Das vom Ultraschallempfänger 1 erzeugte erste analoge Signal HF0° läuft dem von dem zweiten Ultraschallwandler 2 generierte zweite analoge Signal HF90° mit einem Phasenversatz von λ/4 vor.

Die Signalverarbeitungseinheit 3 weist einen analogen Teil 6 und einen digitalen Teil 7 auf. Auch wenn die einzelnen Elemente der Signalverarbeitungseinheit 3 in der Darstellung der Fig. 1 nahe beieinander dargestellt sind, so können diese Einzelelemente (auch innerhalb eines Teiles) räumlich deutlich voneinander getrennt angeordnet sein, wenn dies die räumlichen Bedingungen erfordern.

Der analoge Teil 6 der Signalverarbeitungseinheit 3 weist einen Vorverstärker 8 auf. Der Vorverstärker ist als sogenannter "Dual Channel"-Vorverstärker ausgebildet und weist eine Verstärkung von 5 bis 70 dB auf. Als erster Vorverstärker verstärkt der Vorverstärker 8 das erste analoge Signal HF0° in ein erstes verstärktes analoges Signal. Gleichzeitig verstärkt der Vorverstärker als zweiter Vorverstärker das zweite analoge Signal HF90° in ein zweites verstärktes analoges Signal. Das erste und zweite verstärkte analoge Signal werden jeweils einem Analog/Digital-Wandler 9, 10 zugeführt und dort in ein erstes digitales Signal bzw. in ein zweites digitales Signal umgewandelt. Die Analog/Digital-Wandler 9 und 10 weisen eine Taktfrequenz von 80 MHz auf und eine Auflösung von 14 Bit. Das erste und zweite digitale Signal sind damit 14 Bit-Signale.

Das erste und zweite digitale Signal werden einem Bauelement zur Richtungsauswertung 11 zugeführt. Dieses Bauelement zur Richtungsauswertung 11 generiert ein digitales Signal, das nur dann Werte unterschiedlich von Null annimmt, wenn die Ultraschallwelle an den Ultraschallwandlern 1, 2 in einer vorbestimmten Richtung passiert. Für eine Ultraschallwelle, die die Ultraschallwandler 1, 2 in der Gegenrichtung passiert, nimmt dieses digitale Signal nach dem Bauelement zur Richtungsauswertung 11 einen Wert von Null an. Das erzeugte digitale Signal ist ein 16 Bit-Signal.

Das so erzeugte digitale Signal wird einem Down-Converter 12 zugeführt und dort von einem Signal mit 16 Bit und 80 MHz auf ein Signal von 24 Bit und 1 MHz demoduliert. Dabei wird aus dem 16 Bit-Signal die Trägerfrequenz ausgefiltert und lediglich das Informationen enthaltende Nutzsignal herausgefiltert. An den Down-Converter 12 ist ein Konverter 13 angeschlossen, um lineare Daten in logarithmische Daten umzuwandeln, beispielsweise mittels Tabellen. Das dadurch entstehende 8 Bit-Signal wird einem Median-Filter 14 und einem Schalter 15 zugeführt. Das Ausgangssignal des Median-Filters 14 wird ebenfalls dem Schalter 15 zugeführt. Das Ausgangssignal des Schalters 15 wird einem Konverter 16 zugeführt, der logarithmische Daten in lineare Daten umwandelt. Die Ausgangssignale des Schalters 15 und des Konverters 16 werden einem weiteren Schalter 17 zugeführt. Das Ausgangssignal des Schalters 17 wird einem Digital/Analog-Wandler 18 zugeführt, dessen analoges Ausgangssignal auf der Anzeige 5 ausgegeben werden kann. Das Ausgangssignal des Schalters 17 wird ferner einem Datenverarbeitungsmodul 19 zugeführt. Das Datenverarbeitungsmodul 19 kann eine erste Analyse der Daten durchführen. Ferner kann das Datenverarbeitungsmodul 19 eine Kompression der Daten durchführen. Das Ausgangssignal des Datenverarbeitungsmoduls 19 wird dem TCP/IP-Ethernet-Anschluss 4 zugeführt.

Das Bauelement zur Richtungsauswertung 11 weist einen Multiplizierer 20 auf, der das erste digitale Signal mit einem einstellbaren Faktor multipliziert. Ferner weist das Bauelement zur Richtungsauswertung 11 ein Verzögerungsglied 21 auf, das das zweite digitale Signal um eine einstellbare Verzögerung verzögert. Ein ebenfalls in dem Bauelement zur Richtungsauswertung 11 vorgesehener Addierer 22 addiert das Ausgangssignal des Multiplizierers 20 und das Ausgangssignal des Verzögerungsglieds 21.

Der "Down-Converter" 12 führt (zumindest annähernd) eine Hilbert-Transformation durch. Hierzu weist der "Down-Converter" 12 ein Bauelement 23 mit einem I/Q-Mischer und ein nachgeschaltetes Bauelement 24 mit einem "Cartesian-to-Polar"-Konverter auf. Als Teil des Bauelements 23 mit einem I/Q-Mischer ist ferner ein NCO und ein CIC-Filter vorgesehen. In dem Bauelement 24 mit einem "Cartesian-to-Polar"-Konverter ist ferner ein FIR-Filter vorgesehen.

Um die einzelnen Bauelemente der Signalverarbeitungseinheit 3 zu kontrollieren, weist die Signalverarbeitungseinheit 3 ferner eine Regeleinheit 25 und eine Kontrolleinheit 26 auf. Ferner ist eine Sender-Kontrolleinheit 27 vorgesehen. Die Regeleinheit 25 analysiert das erste und zweite digitale Signal, nimmt einen Trigger der Senderkontrolleinheit 27 auf und wertet Befehle der Kontrolleinheit 26 bezüglich des Multiplikationsfaktors für den Multiplizierer 20, die Verzögerung für das Verzögerungsglied 21 und einen Schaltbefehl zwischen manueller und automatischer Steuerung aus. Ferner analysiert die Regeleinheit das Ausgangssignal des Bauelements für die Richtungsauswertung 11. Die Regeleinheit 25 regelt den Multiplikationsfaktor des Multiplizierers 20 und die Verzögerung des Verzögerungsglieds 21.

Die Kontrolleinheit 26 übermittelt der Sender-Regeleinheit 27 Informationen über die vom Sender auszusendende Sendefrequenz, über die Wiederholungsrate für das auszusendende Signal, um damit eine Sequenz von auszusendenden Signalen zu erzeugen. Ferner übergibt die Kontrolleinheit 26 ein "Burst-Count"-Signal an die Sender-Regeleinheit 27. Das "Burst-Count"-Signal gibt an, mit wieviel Bursts der EMAT das Ultraschallsignal erzeugt.

Die Sender-Regeleinheit 27 steuert den (nicht dargestellten) Ultraschallsender. Insbesondere regelt die Sender-Regeleinheit 27 den Zeitpunkt der Ultraschallsignalabgabe, die Frequenz des abgegebenen Ultraschallsignals und die Wiederholungsfrequenz des abgegebenen Ultraschallsignals.

Die Kontrolleinheit 26 steuert den Schalter 15 und den Schalter 17. Diese Schalter sind optionale Elemente, mit der die Art der Ausgabesignale variiert werden kann. Der Schalter 15 erlaubt es, Rohdaten oder durch das Median-Filter gefilterte Daten auszugeben. Durch die Analyse der Rohdaten im Vergleich zu den durch das Median-Filter gefilterten Daten kann beispielsweise die Wirksamkeit des Median-Filters überprüft werden. Der Schalter 17 erlaubt es, zwischen logarithmisch dargestellten Daten oder linear dargestellten Daten auszuwählen.

Die Kontrolleinheit 26 steuert ferner das Filter des Bauelements 23 und das FIR-Filter des Bauelements 24.

Zur zerstörungsfreien Materialprüfung wird von einem (nicht dargestellten) Ultraschallsender eine Sequenz von Ultraschallsignalen durch einen Prüfkörper gesendet. Der Prüfkörper kann beispielsweise ein unter dem Ultraschallsender hindurchgeführtes, bewegtes Band sein. Vorzugsweise wird das Ultraschallsignal quer zur Bandlaufrichtung ausgesendet. Der vorzugsweise im Bereich des Ultraschallsenders angeordnete Ultraschallempfänger nimmt das vom Ultraschallsender ausgesandte Signal und Reflexionen dieses Signals als ein Signal auf. Die Aufnahme des nächsten Signals beginnt mit dem Aussenden des nächsten Ultraschallsignals durch den Ultraschallsender. Der Abstand zwischen den einzelnen von dem Ultraschallsender ausgesendeten Signalen ist derart gewählt, dass die Anregung des Prüfkörpers durch ein erstes Ultraschallsignal vollständig abgeklungen ist, bevor das zweite Ultraschallsignal ausgesendet wird. Dadurch wird verhindert, dass der Ultraschallempfänger aus dem ersten und dem zweiten Ultraschallsignal überlagerte Werte aufnimmt. Bei der Bandprüfung werden 100 bis 150 Ultraschallsignale pro Sekunde ausgesendet. Je nach Form des Prüfkörpers ist es jedoch durchaus denkbar, deutlich mehr Signale pro Sekunde auszusenden, insbesondere bei solchen Prüfkörpern, bei denen sich das Signal rasch tot läuft, bzw. bei denen das Signal stärker gedämpft wird.

Abhängig von der räumlichen Anordnung des ersten Ultraschallwandlers 1 und des zweiten Ultraschallwandlers 2 läuft das zu empfangende Ultraschallsignal beispielsweise zunächst am Ultraschallwandler 2 und dann am Ultraschallwandler 1 vorbei. Dabei sind die Frequenz des Ultraschallsignals und die räumliche Anordnung der Ultraschallwandler 1, 2 zueinander derart aufeinander abgestimmt, dass der Abstand zwischen dem Ultraschallwandler 1 und dem Ultraschallwandler 2 eine Viertelwellenlänge (λ/4) des Ultraschallsignals ausmacht.

Die als EMAT ausgebildeten Ultraschallwandler 1, 2 wandeln das Ultraschallsignal in ein erstes analoges Signal HF0° und ein zweites analoges Signal HF90° und führen diese Signale dem Vorverstärker 8 zu. Dieser Vorverstärker 8 ist als konstanter, nicht steuerbarer Vorverstärker ausgebildet. Er verstärkt das erste und zweite analoge Signal mit einem konstanten Verstärkungsfaktor. Die verstärkten Signale werden den Analog/Digital-Wandlern 9, 10 zugeführt. Diese tasten die analogen Signale mit einer Tastfrequenz von 80 MHz ab und bilden zwei 14-Bit Signale.

In dem Bauelement zur Richtungsauswertung wird das zweite digitale um eine Verzögerung von t/4 verzögert. Bei der anschließenden Addition der bearbeiteten Signale addieren sich die Signale konstruktiv, wenn das Ultraschallsignal in der vorgegebenen Richtung an den Ultraschallwandlern vorbeigelaufen ist. Die Signale löschen sich gegenseitig aus, wenn das Ultraschallsignal in die entgegengesetzte Richtung an dem Ultraschallwandler vorbeigelaufen ist. Durch den Multiplizierer kann die Amplitude des ersten digitalen Signals derart angepaßt werden, dass eine vollständige Aufhebung stattfindet, wenn das Ultraschallsignal die Ultraschallwandler 1, 2 in Gegenrichtung passiert.

Der digitale Down-Converter 12 führt eine Hilbert-Transformation durch. In dem Down-Converter 12 wird eine Demodulation des Signals durchgeführt. Das durch die Demodulation herausgefilterte, zu analysierende Signal wird als 24-Bit Signal einem Konverter 13 zugeführt, um in ein logarithmisches Signal umgewandelt zu werden. Hierdurch kann das 24-Bit-Signal in ein 8-Bit Signal verdichtet werden. Das 8-Bit Signal wird dem Schalter 15 und dem Median-Filter 14 zugeführt. Das Median-Filter 14 übermittelt in der weiter unten detailliert beschriebenen Weise aus n empfangenen Ultraschallsignalen ein Ausgabesignal, bei dem stochastische Störungen, die asynchron mit der Signalwiederholfrequenz auftreten, ausgefiltert sind.

Durch die nachfolgenden Schalter 15, 17 kann der Benutzer wählen, ob er die Rohdaten in logarithmischer oder linearer Form ausgeben lässt oder ob er die median-gefilterten Daten in logarithmischer oder linearer Form ausgeben lässt. Als Ausgabe besteht die Möglichkeit der Darstellung der Anzeige 5 oder der Übergabe der Daten über den Ethernet Anschluss 4 an einen weiteren Rechner.

Über den Ethernet Anschluss 4 können zum einen die Ausgangssignale übertragen werden. Zum anderen können über diesen Anschluss Kontrolldaten in die Signalauswerteeinheit 3 eingespeist werden. Hierdurch wird beispielsweise eine externe Fehleranalyse, beispielsweise über das Internet, möglich. Auch besteht die Möglichkeit, die Messdaten über weite Distanzen zu senden.

Nachfolgend wird die Arbeitsweise des Median-Filters 14 näher erläutert. Dabei wird ein Median-Filter erläutert, der aus fünf Werten einen Median-Wert ermittelt. Im Rahmen der Erfindung kann das Median-Filter auch aus einer anderen Anzahl von Werten, beispielsweise drei oder sieben einen Median-Wert ermitteln.

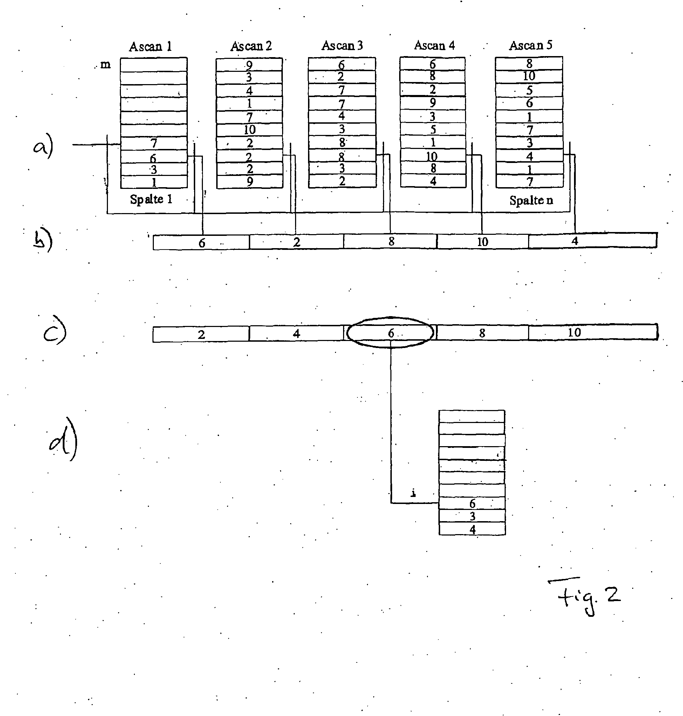

Das Median-Filter 14 weist fünf Arrays auf. Jeder Array hat m Zeilen, wobei der Wert m der Anzahl der Abtastpunkte eines Signals entspricht. Am Anfang der Messung weisen alle Arrays vorzugsweise den Wert 0 auf. Während der Auswertung des ersten empfangenen Ultraschallsignals wird der erste Array mit Werten gefüllt. Nach Abschluss der Analyse des ersten Ultraschallsignals ist der erste Array vollständig mit Werten gefüllt. Diese Werte werden vollständig an den zweiten Array übergeben. Mit Beginn der Analyse des zweiten empfangenen Ultraschallsignals wird der erste Array mit neuen, aus der Analyse des zweiten Ultraschallsignals stammenden Werten gefüllt. Nach Abschluss der Analyse des zweiten Ultraschallsignals werden die Werte des zweiten Arrays an den dritten Array vollständig übergeben, während die Werte des ersten Arrays an den zweiten Array vollständig übergeben werden. Die Ergebnisse der Analyse des dritten Ultraschallsignals werden in den ersten Array geschrieben. Diese Übergabe der Werte von dem einen Array auf den nachfolgenden Array und das Überschreiben der Werte des ersten Arrays durch Werte aus der Analyse des aktuell analysierten Ultraschallsignals wird fortlaufend fortgeführt. Zu jedem Zeitpunkt befinden sich somit in den Arrays 2, 3, 4, 5 die Ergebnisse der Analyse des zweitletzten, drittletzten, viertletzten und fünftletzten Ultraschallsignals. In dem ersten Array werden stets die aktuellen Abtastwerte eingetragen (Fig. 2a).

Ein Ergebnis-Array gibt das Ergebnis der Median-Filterung wieder. Das Ergebnis-Array weist die gleiche Anzahl von Zeilen auf, wie die fünf Arrays. In die jeweilige Zeile des Ergebnis-Arrays wird der Wert eingetragen, der sich aus der Median-Filterung der in der entsprechenden Zeile in den fünf Arrays stehenden Werte ergibt (Fig. 2d).

Hierzu liest das Median-Filter die entsprechende Zeile aus (Fig. 2b), sortiert die Werte der Größe nach (Fig. 2c) und nimmt den Wert, der in der Mitte steht.

Die Median-Filterung kann für den jeweiligen Abtastpunkt erfolgen, sobald der jeweilige neue Abtastpunkt des gerade analysierten Ultraschallsignals an den entsprechenden Zeilenort in dem ersten Array geschrieben wird. Nach einer kurzen Anlaufphase (Füllen der ersten drei Arrays) kann dann in Echtzeit die Ausgabe Median-gefilterter Ergebnisse erfolgen.

## Patentansprüche

1. Ultraschallempfänger mit einem Ultraschallwandler (1, 2) zum Erzeugen eines analogen Signals, einem Analog/Digital-Wandler (9, 10) zum Erzeugen eines digitalen Signals und einem Demodulator (12) zum Erzeugen eines demodulierten digitalen Signals,**dadurch gekennzeichnet, dass** das demodulierte digitale Signal aus einer Reihe von Werten besteht, bei der der in der Reihe jeweils nachfolgende Wert den Wert der nächsten Abtastung wiedergibt und die Reihe m Werte aufweist, wobei m die Zahl der Abtastungen in dem für die Erzeugung des demodulierten digitalen Signals beobachteten Fenster ist, sowie ein Median-Filter (14) vorgesehen ist, das die Reihe der abgetasteten Werte in einen Array aufnimmt und für die Reihe der Abtastwerte des nächsten Signals ein weiterer Array beschrieben wird, wobei durch den vergleichbaren Anfangszeitpunkt der für die Signalerzeugung beobachteten Fenster und die gleiche Abtastung an gleichen Stellen des jeweiligen Arrays die an dem im Vergleich zum Anfangszeitpunkt jeweils gleichen Abtastzeitpunkt abgetasteten Werte abgelegt sind, wobei n Arrays beschrieben werden, wobei n die Zahl der Signale ist, die das Median-Filter auswertet, um ein Ergebnis-Array zu erzeugen, wobei das Median-Filter (14) für die Filterung eines Abtastpunkts die n diesem Abtastpunkt zugeordneten Werte in den Arrays ausliest, die ausgelesenen Werte ihrer Größe nach sortiert und den Wert in der Mitte (Median-Wert) ausgibt, wobei der Wert in der Mitte in ein Ergebnis-Array geschrieben wird.

2. Ultraschallempfänger nach Anspruch 1, **dadurch gekennzeichnet, dass** der Analog/Digital Wandler (9, 10) eine Auflösung von mindestens 14-Bit und eine Taktfrequenz von mindestens 50 MHz aufweist.

3. Ultraschallempfänger nach einem der Anspruche 1 oder 2, **dadurch gekennzeichnet, dass** der Demodulator (12) eine Hübert-Transformation eines digitalen Signals durchführt.

4. Ultraschallempfänger nach einem der Ansprüche 2 bis 4, **dadurch gekennzeichnet, dass** der Demodulator (12) ein NCO (numerically controlled oscillator), einen I/Q- Mischer (In phase and Auacharuse-Mischer) und ein CIC-Filter (cascaded-integrator-camb-Filter), ein FIR-Filter (finite-imputs-response-filter) und einen "Cartesian-to-Polar'-Konverter aufweist.

5. Ultraschallempfänger nach einem der Ansprüche 1 bis 4, **gekennzeichnet durch** einen schaltbaren Bypass (15) für das Median-Filter.

6. Ultraschallempfänger nach einem der Ansprüche 1 bis 5, **gekennzeichnet durch** einen Ethernet-Anschluss (4).

7. Ultraschallempfänger nach einem der Ansprüche 1 bis 6 mit einem ersten Ultraschallwandler (1) zum Erzeugen eines ersten analogen Signals, einem ersten Analog/Digital-Vandler (9) zum Erzeugen eines ersten digitalen Signals, einem zweiten Ultraschaliwandler (2) zum Erzeugen eines zweiten analogen Signals, einem zweiten Analog/Digital-Wandler (10) zum Erzeugen eines zweiten digitalen Signals, und einem Demodulator (12) zum Erzeugen eines demodulierten digitalen Signals.

8. Ultraschallempfänger nach Anspruch 7, **gekennzeichnet durch** einen Multiplizierer (20) für das erste digitale Signal, einem Verzögerungsglied (21) für das zweite digitale Signal und einem Addierer (22) zur Addition des digitalen Ausgangssignal des Multiplizierers (20) und des digitalen Ausgangssignals des Verzögerungsglieds (21).

9. Ultraschallempfänger nach Anspruch 8, **gekennzeichnet durch** einen Multiplizierer (20) mit einstellbarem Multiplikationsfaktor.

10. Ultraschallempfänger nach einem der Anspruche 8 oder 9, **gekennzeichnet durch** ein Verzögerungsglied (21) mit einstellbarer Verzögerung.

11. Ultraschallempfänger nach einem der Ansprüche 9 oder 10, **gekennzeichnet durch** ein Analyseglied (25) zur Beobachtung des ersten und des zweiten digitalen Signals und Ermittlung, Regeln oder Steuern des Multiplikationsfaktors und/oder der einzustellenden Verzögerung.

## Claims

1. Ultrasonic receiver having an ultrasonic transducer (1, 2) for producing an analogue signal, an analogue/digital converter (9, 10) for producing a digital signal and a demodulator (12) for producing a demodulated, digital signal, **characterised in that** the demodulated, digital signal consists of a row of values in which each subsequent value in the row reproduces the value of the next sampling and the row has m values, wherein m is the number of samplings in the window observed for producing the demodulated, digital signal, and a median filter (14) is provided which assembles the row of sampled values into an array and a further array is described for the row of sampled values of the next signal, wherein by means of the comparable starting point in time for the windows observed for producing the signal and by means of the same sampling at the same places in the respective array, the values sampled in each case at the same sampling point in time in comparison to the starting point in time are stored, wherein n arrays are described, wherein n is the number of signals which the median filter evaluates in order to produce a result array, wherein to filter a sampling point the median filter (14) reads the n values assigned to this sampling point in the arrays, sorts the values read according to their size and outputs the value in the middle (median value), wherein the value in the middle is written to a result array.

2. Ultrasonic receiver according to Claim 1, **characterised in that** the analogue/digital converter (9, 10) has a resolution of at least 14 bits and a clock frequency of at least 50 MHz.

3. Ultrasonic receiver according to, Claim 1 or 2, **characterised in that** the demodulator (12) carries out a Hilbert transformation of a digital signal.

4. Ultrasonic receiver according to any one of Claims 2 to 4, **characterised in that** the demodulator (12) has an NCO (numerically controlled oscillator), an I/Q mixer (in-phase and quadrature mixer) and a CIC filter (cascaded-integrator comb filter), an FIR filter (finite impulse response filter) and a Cartesian-to-polar converter.

5. Ultrasonic receiver according to any one of Claims 1 to 4, **characterised by** a switchable bypass (15) for the median filter

6. Ultrasonic receiver according to any one of Claims 1 to 5, **characterised by** an Ethernet connection (4).

7. Ultrasonic receiver according to any one of Claims 1 to 6, having a first ultrasonic transducer (1) for producing a first analogue signal, a first analogue/digital converter (9) for producing a first digital signal, a second ultrasonic transducer (2) for producing a second analogue signal, a second analogue/digital converter (10) for producing a second digital signal and a demodulator (12) for producing a demodulated, digital signal.

8. Ultrasonic receiver according to Claim 7, **characterised by** a multiplier (20) for the first digital signal, a delay element (21) for the second digital signal and an adder (22) for adding the digital output signal of the multiplier (20) and the digital output signal of the delay element (21).

9. Ultrasonic receiver according to Claim 8, **characterised by** a multiplier (20) having an adjustable multiplication factor.

10. Ultrasonic receiver according to either of Claims 8 and 9, **characterised by** a delay element (21) having an adjustable delay.

11. Ultrasonic receiver according to either of Claims 9 and 10, **characterised by** an analyser (25) for observing the first and second digital signals and for determining, regulating or controlling the multiplication factor and/or the delay to be adjusted.

## Revendications

1. Récepteur ultrasonore avec un transducteur ultrasonore (1, 2) pour générer un signal analogique, un convertisseur analogique/numérique (9, 10) pour générer un signal numérique et un démodulateur (12) pour générer un signal numérique démodulé, **caractérisé en ce que** le signal numérique démodulé est composé d'une série de valeurs dans laquelle la valeur chaque fois suivante dans la série reproduit la valeur de l'échantillonnage suivant et la série comporte m valeurs, m étant le nombre d'échantillonnages dans la fenêtre observée pour la génération du signal numérique démodulé, un filtre médian (14) étant prévu qui enregistre la série des valeurs échantillonnées dans un réseau et un autre réseau étant décrit pour la série des valeurs échantillonnées du prochain signal, sachant qu'en raison de l'instant initial comparable des fenêtres observées pour la génération de signaux et du même échantillonnage, des valeurs échantillonnées au même instant d'échantillonnage par rapport à l'instant initial sont enregistrées aux mêmes endroits du réseau respectif, n réseaux étant décrits, n étant le nombre de signaux que le filtre médian (14) évalue pour générer un réseau résultat, le filtre médian (14) extrayant pour le filtrage d'un point d'échantillonnage les n valeurs associées à ce point d'échantillonnage dans les réseaux, triant les valeurs extraites selon leur grandeur et délivrant la valeur située au milieu (valeur médiane), la valeur située au milieu étant écrite dans un réseau résultat.

2. Récepteur ultrasonore selon la revendication 1, **caractérisé en ce que** le convertisseur analogique/numérique (9, 10) possède une résolution d'au moins 14 bits et une fréquence d'horloge d'au moins 50 MHz.

3. Récepteur ultrasonore selon une des revendications 1 ou 2, **caractérisé en ce que** le démodulateur (12) effectue une transformation de Hilbert d'un signal numérique.

4. Récepteur ultrasonore selon une des revendications 2 à 4, **caractérisé en ce que** le démodulateur (12) présente un NCO (Numerically Controlled Oscillator), un mélangeur I/Q (mélangeur en phase et en quadrature) et un filtre CIC (Cascaded Integrator Comb Filter), un filtre FIR (Finite Impulse Response Filter) et un convertisseur « Cartesian to Polar ».

5. Récepteur ultrasonore selon une des revendications 1 à 4, **caractérisé par** une dérivation commutable (15) pour le filtre médian.

6. Récepteur ultrasonore selon une des revendications 1 à 5, **caractérisé par** une connexion Ethernet (4).

7. Récepteur ultrasonore selon une des revendications 1 à 6 avec un premier transducteur ultrasonore (1) pour générer un premier signal analogique, un premier convertisseur analogique/numérique (9) pour générer un premier signal numérique, un deuxième transducteur ultrasonore (2) pour générer un deuxième signal analogique, un deuxième convertisseur analogique/numérique (10) pour générer un deuxième signal numérique et un démodulateur (12) pour générer un signal numérique démodulé.

8. Récepteur ultrasonore selon la revendication 7, **caractérisé par** un multiplicateur (20) pour le premier signal numérique, un élément de retard (21) pour le deuxième signal numérique et un additionneur (22) pour additionner le signal de sortie numérique du multiplicateur (20) et le signal de sortie numérique de l'élément de retard (21).

9. Récepteur ultrasonore selon la revendication 8, **caractérisé par** un multiplicateur (20) à facteur de multiplication réglable.

10. Récepteur ultrasonore selon une des revendications 8 ou 9, **caractérisé par** un élément de retard (21) à retard réglable.

11. Récepteur ultrasonore selon une des revendications 9 ou 10, **caractérisé par** un élément d'analyse (25) pour observer le premier et le deuxième signal numérique et déterminer, réguler ou commander le facteur de multiplication et/ou le retard à régler.
